# EUROPEAN PATENT SPECIFICATION

(11) **EP 0 721 397 B1**
(45) Date of publication and mention of the grant of the patent: **21.10.1998**
(21) Application number: 94929362.5
(22) Date of filing: 27.09.1994
(51) Int. Cl.: B41N 3/03

(54) **PROCESS FOR PREPARING IMPROVED LITHOGRAPHIC PRINTING PLATES**
VERFAHREN ZUR HERSTELLUNG LITHOGRAPHISCHER DRUCKFARBEN
PROCEDE DE PREPARATION DE PLAQUES D'IMPRESSION LITHOGRAPHIQUES AMELIOREES

(30) Priority: 29.09.1993 US 128925
(43) Date of publication of application: 17.07.1996
(73) Proprietor: Bayer Corporation, Pittsburgh, PA 15219-2502 (US)
(72) Inventor: SPRINTSCHNIK, Gerhard, Somerville, NJ 08876 (US); WANAT, Stanley F., Scotch Plains, NJ 07076 (US); DHILLON, Major S., Belle Mead, NJ 08502 (US); LOVELAND, Allen W., Washington, NJ 07882 (US); KING, Dennis A., Edison, NJ 08817 (US)
(74) Representative: Zounek, Nikolai, Dipl.-Ing.
(86) International application number: US9410933
(87) International publication number: WO9509086

(56) References cited:
- DE-A- 3 842 454
- GB-A- 1 582 620
- US-A- 3 220 832
- US-A- 4 376 814
- US-A- 4 502 925
- DATABASE WPI Derwent Publications Ltd., London, GB; AN 90-020105 & JP,A,1 301 289 (FUJI PHOTO) 5 December 1989

## Description

### FIELD OF THE INVENTION

This invention discloses a process for preparing improved lithographic plates and improved lithographs prepared therefrom.

### BACKGROUND OF THE INVENTION

The art of lithography is well known and is practiced commercially in several fields including, for example, the electronic industry, newspaper industry, magazines, and the like. The field of lithography has been extensively written and commented upon in several books and articles. See, for example, *Kirk-Othmer*, *Encyclopedia of Chemical Technology*, Vol. 19, p. 140, John Wiley & Sons (1982); *ibid*, Vol. 20, p. 161 (1982); and *Encyclopedia of Polymer Science and Engineering*, Vol. 13, p. 373, John Wiley & Sons (1988).

A typical lithographic printing plate comprises a substrate surface, typically made of aluminum, silicon and the like, with a photosensitive layer on top. The preparation of the lithographic printing plate generally comprises cleaning the aluminum base, roughening it to make it suitable to receive the layers that go on top, anodically oxidizing it, followed by conditioning the surface and depositing the photosensitive layer on top. If defects occur in any of these steps, the quality of the printing plate suffers. Thus, for example, when the conditioning process is not of optimum quality, it affects the sensitivity to the background in the printed images, resulting in "toning". Copending patent application, Serial number 08/128,911, filed of even date herewith (=EP-A-0721607), describes an improved process for conditioning and improving the hydrophilicity of the plate.

The document GB-A 1,582,620 is related to a process to prepare a lithographic printing plate comprising the steps of graining mechanically a substrate of a suitable metal and graining the substrate electrochemically in an acid medium with alternating current. Thereafter a photosensitive layer is applied to the conditioned substrate.

US-A-4,502,925 discloses a method for treating an aluminum substrate, which is grained and anodized, with a hydrophilizing agent such as polyvinylphosphonic acid.

The treatment of a grained aluminum substrate with polyvinyl phosphonic acid is also disclosed in US-A-3,220,832.

US-A-4,376,814 is related to an aluminum substrate onto which a ceramic surface coating is electrochemically or thermally deposited. The ceramic coating comprises an organic acid such as polyvinylphosphonic acid and an alkaline earth silicate or borate. In preparing the coating composition an aqueous solution of polyvinylphosphonic acid is titrated with a monovalent alkali until an alkaline pH of at least about 8,0, preferably from about 8.0 to about 10.0 is obtained.

The roughening ("graining") step is another area of concern in the lithographic industry. Traditionally roughening of aluminum plates is performed by electrochemical or mechanical process. The mechanical process includes processes such as ball graining, brush graining, and the like. Copending patent application, Serial No. 08/128,913, filed of even date herewith (=EP-A-0721607), describes an improved process for mechanical roughening of lithographic plates, the improved process resulting in fewer number of scratches on the plates. Electrochemical graining process to roughen plates has been described, for example, in U. S. Patents 5,174,869; 4,824,757; 4,786,381; 4,746,591; 4,714,528; 4,576,686; 4,545,866; 4,533,444; 4,294,672 and 4,272,342.

U.S. Patent No. 4,561,944 discloses a graining process which employs both mechanical graining and electrochemical graining. The electrochemical graining uses HCl, nitric acid or a mixture thereof and applies an unsymmetrical alternating current so that the ratio of the electricity during the cathodic period versus the anodic period is 1:1 to 2.5:1 and the quantity of electricity during the anodic period is 300 coulombs/dm² or less. Preferred alternating current has voltage during the anodic period lower than the voltage during the cathodic period.

Despite improvements being made to such processes, problems are still seen with the quality of lithographic plates, particularly with background toning. Toning occurs when a photosensitive layer penetrates too deeply into the surface of the plate, resulting in inked areas of the non-imaged portion of the plate.

Thus, it would be desirable to have a process whereby good quality lithographic plates can be produced without the above toning problem.

It would also be desirable to have a process whereby the hydrophilicity of the non-image areas in the surface of printing plate substrates can be improved, thus improving the quality of images printed therefrom.

### SUMMARY OF THE INVENTION

Applicants have discovered that improved lithographic plates are produced by a process comprising: a mechanical graining process, an electrochemical graining process and a conditioning process, wherein the electrochemical graining is performed in a suitable acid medium with symmetrical alternating current in the range of about 10-500 Amperes/dm², and wherein the conditioning is performed with a solution of polyvinylphosphonic acid suitably partially neutralized to be in the pH range of about 2.5 to 6.0. The preparation and use of suitable partially neutralized polyvinylphosphonic acid are described in copending patent application, Serial No. 08/128,911 (EP-A-0721607), referred to above. The inventive process not only results in improved adhesion in the lithographic plates but also substantially improves the hydrophilicity of the non-image areas in the surface as well as eliminates the background toning problem. This in turn results in printed images with excellent contrast, sharpness and brightness.

### DESCRIPTION OF THE PREFERRED EMBODIMENTS

An embodiment of the present invention discloses a process to prepare improved lithographic plates. Another embodiment includes improved lithographic printing plates prepared using the inventive process. The inventive process comprises the steps of mechanical graining, electrochemical graining and conditioning of the substrate plate. The order of the graining processes is preferably mechanical graining first, followed by elctrochemical graining, in which case the mechanical graining produces a primary graining effect and the electrochemical graining produces a secondary graining effect. Combining these steps with a suitable conditioning step produces a synergistic effect, yielding lithographic plates with excellent adhesion, contrast and no background toning.

The following description illustrates the advantages of using the inventive combination steps. For illustration, the primary graining described is mechanical, and the secondary graining is electrochemical, although the reverse may also be employed within the scope of this invention. The process starts with a suitable substrate. Suitable substrates include metal, silicon, and the like materials which are well known in the art. Suitable metals for lithographic use are steel, magnesium or aluminum and its alloys. Aluminum and its alloys are preferred because of their excellent mechanical properties and relatively light weight. Of particular interest are alloys which maintain the advantages of aluminum but offer mechanical strength to prevent cracking or tearing during long runs on printing presses. The substrate may be in the form of a plate, coil, web and the like. While the inventive process may be conceivably used on a wide variety of substrate materials, this description illustrates the use of the process with aluminum substrates.

The aluminum substrate is first cleaned to remove milling oils and surface impurities. Cleaning may be done by a variety of solvent or aqueous alkaline treatments. Typical alkaline degreasing agents include: hot aqueous solutions containing alkalis such as potassium hydroxide, sodium hydroxide, trisodium phosphate, sodium silicate, and aqueous alkalis mixed with surfactants. Solvent type degreasers such as trichloroethylene, 1,1,1 trichloroethane, perchloroethylene can be used but are less popular because of increasing environmental and health considerations. The degreasing may be done by immersion, spray or vapor washing with the listed agents.

The cleaned aluminum surface is then subjected to the mechanical graining process. Several mechanical graining processes are well known in the art may be used in the practice of the present invention. Such processes generally include ball graining, brush graining and the like. A suitable process is brush graining, wherein the lithographic substrate plate is generally brushed with a brush in a slurry comprising particles suitable for roughening the plate. For example, U.S. Patent No. 4,183,788 discloses a brush graining process wherein the lithographic base is grained with an aqueous slurry comprising unfused, platy crystalline alumina using a rotary brushing motion whose force is predominantly tangential to the surface of the base plate. Other processes use silica (quartz) as the particles. Copending patent application, Serial No. 08/128,913, filed of even date herewith (EP-A-0721607), discloses a mechanical graining process which is preferred in the practice of the present invention. This brush graining process employs an aqueous slurry comprising a mixture of alumina and quartz, and results in advantages such as much fewer scratches on the plate than when using a slurry containing alumina alone.

In this preferred process, the graining is done using one or more brushes in an aqueous slurry comprising a mixture of fine alumina and fine quartz. The terms "fine alumina" and "fine quartz" respectively refer to alumina and quartz particulates with a mean particle size generally in the range of about 1-20 µm (microns), preferably about 1-10 µm (microns) and typically about 3-6 µm (microns), as measured by the Microtrac instrument (supplied by Leeds and Northrup, St. Petersburg, Florida). The amount of quartz in the mixture of alumina and quartz generally ranges from about 5-95 weight %, preferably about 5-50 weight %, and typically about 10-20 weight %.

The particulate alumina used in the invention is unfused, anhydrous, crystalline alumina having a plate-like or tablet-like particle configuration. The flat dimension is generally three to five times greater than the thickness. This form of alumina can be obtained from hydrated alumina but is generally made from α-alumina trihydrate. Alumina useful in the practice of the invention is commercially available from suppliers such as, for example, Alcoa Surface Treatments, Bauxite, Arkansas.

The particulate quartz used in the present invention has an angular configuration. Useful grade quartz is commercially available from Agsco Corporation, Hasbrouk heights, New Jersey.

To form the mechanical graining medium, alumina and quartz are mixed in the desirable ratio described above, and made into a slurry in water. The solids concentration in the aqueous abrasive slurry is generally about 5-50 weight %, preferably about 10-40 weight % and typically in the range 15-30 weight %. The alumina and quartz may be first mixed together and then mixed with the water to prepare the slurry; alternatively, the two particulate materials may be added one after the other, in any order, to the water, to form the slurry. During the graining process, the slurry is kept in a continuously agitated condition.

The mechanical graining of the aluminum base plate may be done by the brush graining technique. Conventional methods generally employ a plurality of rotating brushes. U. S. Patent No. 4,183,788, referred to above, describes such a process whereby the graining is done while applying a rotary brushing motion whose force vector is predominantly tangential to the surface of the aluminum, using a plurality of brushes. While the instant invention may be practiced using such conventional processes, inventors have found that use of a single brush moving counter to the base plate as disclosed in the afore-mentioned copending patent application, Serial No. 08/128,913 (=EP-A-0721607), is generally adequate and also results in a superior quality grained plate. Whichever brushing technique is used, generally a mean roughness of about 0.2 to about 1.0 Ra is produced in a typical graining process. Ra is a measurement of average roughness of the surface and is defined as the arithmetic average of all departures of the roughness profile from the center line within the desired evaluation length.

After the primary graining is done mechanically as described above, it is followed by electrochemical graining of the plate. As in the case of the mechanical graining, the electrochemical graining may also be done by conventional methods. For example, U.S. Patents 5,174,869 and 5,114,825 describe suitable elctrochemical graining processes. A preferred process for the present invention employs an acid medium such as, for example, nitric acid, hydrochloric acid, mixtures thereof and the like. An electrolyte such as, for example, aluminum nitrate is added to the medium. The process employs symmetrical alternating current generally in the range of about 10-500 amperes/dm², preferably about 10-300 amperes/dm² and typically about 20-200 amperes/dm². The concentration of the acid is generally in the range of about 2-50 g/l, preferably about 5-25 g/l and typically about 10-20 g/l. The concentration of the electrolyte is generally in the range of about 10-200 g/l, preferably about 25-150 g/l and typically about 40-80 g/l.

After the graining step is completed, the substrate plate may be further processed through a series of steps. Some such further processing steps may include etching, rinsing, anodizing, conditioning, coating with a photosensitive layer, and the like. Copending patent application, Serial No. 08/128,911, filed of even date herewith (EP-A-0721607), describes some of these steps. Sometimes it is advantageous to have the etching step immediately following the primary graining step, but before the secondary graining step.

If etching of the substrate is desired, the substrate may be optionally etched in aqueous caustic or acid baths to remove surface deposits generated by graining and aerial oxide formed on the labile aluminum surface. Etching is followed by rinsing. Steps following surface roughening are preferably, though not exclusively, done with the metal kept wet.

The metal surface may then be optionally anodized ("oxidized") to improve surface hardness and wear resistance of the final product. Anodization is typically carried out in aqueous inorganic electrolyte baths where the aluminum surface acts as the anode in an electrochemical process. Preferred electrolytes are the strong acids such as sulfuric and phosphoric. Organic acids and mixtures may additionally be used to impart specific properties to the final product. Anodization is generally performed at temperatures between ambient to about 100°C, as is well known to those skilled in the art. Generally an oxide weight of about 0.25-3.5 gram/m² is built on the surface in a typical lithographic plate process.

The anodized plate is then rendered more hydrophilic by a conditioning ("sealing") process. U.S. Patent No. 4,153,461 discloses the use of polyvinylphosphonic acid ("PVPA") as a conditioning agent. Copending patent application, Serial No. 08/128,911 (EP-A-0721607), referred to above, describes an improved conditioning process which comprises using a conditioning reagent comprising PVPA solution partially neutralized to, and maintained at, a pH of about 2.5 to 6.6. Such an improved conditioning process renders the surface more hydrophilic, thereby requiring fewer number of sheets to clean out when the lithographic printing plate is ultimately utilized to make prints.

Following the above conditioning step, the substrate may be rinsed with water, then dried with forced hot air, and then coated with a photosensitive layer. Photosensitive layers are made from photosensitive compounds that may be optionally mixed with suitable additives such as, for example, binder resins, photoinitiators, colorants, acid stabilizers, exposure indicators, surfactants and the like, known to those skilled in the art. Photosensitive compounds ("light sensitive compounds") useful in the practice of the invention include, for example, those described, in U.S. Patent Nos. 3,849,392; 3,867,147; 4,157,918, and 4,183,788. Additives that may be used in combination with such light sensitive compounds include those described in U.S. Patent No. 3,679,419.

Photosensitive compounds are of two types: positive and negative working types. Positive types are those where the area of the plate exposed by light radiation through a mask are removed in the development step. In negative types, the exposed areas are hardened and remain after development.

Positive working photosensitive materials suitable in the practice of the invention are iminoquinone diazides, ortho-quinone diazides and the like, which contain sulfonic acid esters of such diazides, prepared by reacting the appropriate sulfonyl chlorides with one or more labile aromatic hydroxyl groups. Preferred are the ortho-quinone diazides containing the above-described sulfonic acid ester groups. These esters undergo a photo Wolff rearrangement whereby loss of nitrogen is followed by a ring contraction and generation of a carboxylic acid which is easily removed using alkaline developing solutions. Several such positive acting compounds are described in, for example, U.S. Patents 3,175,906 and 4,157,918.

Negative type photosensitive materials are generally made by using the photo-labile crosslinking capabilities of oligomeric compounds such as, for example, the diazonium compounds, or the photo-polymerization of reactive monomers, or a combination of both. Several are described, for example, in U.S. Patent Nos. 3,849,392; 3,867,147; 4,157,918; 4,183,788 and 5,200,291. These are generally free radical polymerizations which are inhibited by oxygen. Oxygen barrier coatings are generally made atop the photosensitive coating to prevent interference from aerial oxygen when using negative photopolymer products. Generally, the photosensitive layer is selected based on the actinic radiation that is going to be used for exposure, as is known to those skilled in the art. The present invention may be practiced with both positive and negative type photosensitive materials.

The light sensitive compound may optionally be mixed with additives as described above to form a photosensitive coating material, if so desired. For example, acid stabilizers may be used with diazonium compounds; suitable acid stabilizers are generally organic or inorganic acids. Examples include phosphoric, citric, benzoic, m-nitrobenzoic, p-toluenesulfonic, and the like as well as mixtures thereof. Preferably, the acid stabilizer is phosphoric acid. When used, the acid stabilizer is present generally in the amount of from about 0.02 % to about 2 %, and preferably from about 0.05 % to about 1.0 % based on the weight of the composition.

Exposure indicators (or photoimagers) which may be useful in conjunction with the present invention include 4-phenylazodiphenylamine, eosin, azobenzene, Calcozine Fuchsine dyes and Crystal Violet and Methylene Blue dyes. Preferably, the exposure indicator is 4-phenylazodiphenylamine. The exposure indicator, when one is used, is preferably present in the composition in an amount of from about 0.01% to about 0.35% by weight. A more preferred range is from about 0.02% to about 0.30% and, most preferably, the exposure indicator is present in an amount of from about 0.02% to about 0.20%, although the skilled artisan may use more or less as desired.

Colorants useful herein include dyes such as Rhodamine, Calcozine, Victoria Blue and methyl violet, and such pigments as the anthraquinone and phthalocyanine types. Generally, the colorant is present in the form of a pigment dispersion which may comprise a mixture of one or more pigments and/or one or more dyes dispersed in a suitable solvent or mixture of solvents. When a colorant is used, it is preferably present in the composition of this invention in an amount of from about 2.0% to about 35.0% by weight, more preferably from about 5.0% to about 30.0% and most preferably from about 5.0% to about 20% although the skilled artisan may use more or less as desired.

Resin binders may be used in the coating to increase the functional lifetime of the printing plates. If resin binders are desired, suitable binder resins are chosen based upon their compatibility with other coating components, the ability to be cleaned away during the development step in non-image areas of the plate and their resistance to wear on press. Resins with acid end groups are especially desirable since the acid helps stabilize the coatings based upon diazonium compounds and provides alkaline solubility for development.

In order to form a coating composition for the production of the photosensitive layer, the light sensitive compound is coated from a solution in a suitable solvent, wherein the light sensitive compound is present in amounts such that the concentration of the light sensitive compound is generally in the range 10-100% of the total solids in the dried coating upon drying (see below), preferably in the range 30-75%, and typically in the range 40-60%. Suitable solvents for this purpose include water, tetrahydrofuran, butyrolactone, glycol ethers such as propylene glycol monomethyl ether and methyl cellosolve, alcohols such as ethanol and n-propanol, and ketones such as methyl ethyl ketone, or mixtures thereof. Preferably, the solvent comprises a mixture of propylene glycol monomethyl ether and butyrolactone. In general, after the solution is applied to an appropriate substrate by a suitable coating process, the solvent system is evaporated from the coating by a suitable drying process; some insignificant amount of solvent may, however, remain as residue.

The process to coat the light sensitive layer may be a batch or continuous process as is known to those skilled in the art. Some useful coating processes include dip coating, roller coating, slot type coating, spin coating, and the like, which deposit a thin uniform dry photosensitive coating on the surface once the solvents have been driven off. At the end of the coating operation and drying, generally a coating weight of from about 0.5g/m² to about 2.5g/m², preferably from about 0.8 g/m² to about 2.0 g/m² and typically about 1.0 g/m² is obtained.

The advantages of the instant invention may generally be tested at this stage. An important criterion for the performance of the printing plate is the number of sheets needed for cleanout during use. The fewer the number of sheets that are required to clean out the better is the performance of the printing plate. The number of sheets needed for cleanout and to give acceptable impressions may be tested by a toning test in a dry scum cycle using Kohl Madden magenta ink and RC651 fountain solution. Typical experiments using the inventive combinations of mechanical and electrochemical graining and conditioning steps generally yield plates which require less than 50 sheets for cleanout, whereas experiments employing mechanical graining only combined with a conditioning step yielded plates requiring at least 100 sheets for cleanout.

In a process to prepare improved lithographic plates according to another embodiment of the present invention, the photographic element prepared as described above is then exposed to suitable actinic radiation through a negative mask so as to yield a solid 5 on a 21 step Stouffer exposure wedge (supplied by Stouffer Graphic Arts Equipment Company, South Bend, Indiana) after development. Generally a radiation in the range of 300-400 nm is employed. The exposed plate is then developed with a suitable developer. Suitable developer may be aqueous developer, or aqueous developer mixed with a suitable organic solvent. An aqueous developer useful in the present invention comprises an aqueous solution containing one or more of the following groups:
(a) a sodium, potassium or lithium salt of octyl, decyl or dodecyl monosulfate;
(b) a sodium, lithium, potassium or ammonium metasilicate salt;
(c) a lithium, potassium, sodium, or ammonium borate salt;
(d) an aliphatic dicarboxylic acid, or sodium, potassium or ammonium salt thereof having from 2 to 6 carbon atoms; and
(e) mono-, di-, or tri-sodium, or -potassium phosphate.
Other suitable developers include water, benzoic acid or sodium, lithium and potassium benzoates and the hydroxy substituted analogs thereof as well as those developers described in U. S. Patent No. 4,436,807.

In conventional use, the developed plate is finished with a subtractive finisher such as a hydrophilic polymer. Examples include cold water soluble dextrin and/or polyvinyl pyrrolidone, a nonionic surfactant, a humectant, an inorganic salt and water, as taught by U. S. Patent No. 4,213,887.

For the purpose of improving the press performance of a plate prepared as described above, it is known that baking of the exposed and developed plate can result in an increase in the number of quality impressions over that otherwise obtainable. To properly bake the plate, it may be first treated with a suitable solution designed to prevent loss of hydrophilicity of the background during baking. An example of a suitable solution is disclosed in U. S. Patent No. 4,355,096. The plate prepared as above may then be heat treated by baking at temperature of from about 180°C up to the annealing temperature of the substrate, preferably about 240°C. The effective baking time is inversely proportional to the temperature and averages in the range of from about 2 to about 15 minutes.

### EXAMPLES

**Example 1**. **Process using mechanical graining only; comparative example:** A degreased aluminum substrate (web of 1050 alloy) was mechanically roughened by brushing it with a single 60 cm diameter brush rotating at 250 rpm counter to the web direction while using a slurry made of fine grade alumina (∼5 micron mean article size) and fine grade quartz (∼5 micron) (70:30 weight ratio of alumina to quartz) at 15% solids concentration as she abrasive medium. The substrate was then etched, anodized and conditioned with polyvinyl phosphonic acid as described in U.S. Patent No. 4,153,461. Then the substrate was coated with a light sensitive coating. The light sensitive coating consisted of a diazo resin which is the polycondensation product of 3-methoxy-4-diazo diphenyl amine sulfate and 4,4'-bismethoxy methyl-diphenyl ether, precipitated as mesitylene sulfonate, described in U.S. Patent 4,157,918, and a modified polyvinylacetal resin described in U.S. Patent 4,940,646. The coated plate was subjected to a toning test in a dry scum cycle using Kohl Madden magenta ink (Supplied by Kohl Madden Corp., Lodi, New Jersey and RC651 fountain solution (Supplied by Hoechst AG Kalle Werk, Wiesbaden, Germany). The control plate took more than 100 sheets to provide acceptable print impressions.

**Examples 2-7** demonstrate a process practiced by conditioning the surface of a printing plate with polyvinylphosphonic acid and Example 8 demonstrates the inventive process practiced within the scope of the present invention.

**Example 2:** A 1050 aluminum alloy web was degreased, mechanically grained as in Example 1 and etched. The mechanically grained and etched substrate web was then grained with alternating current in nitric acid to form a secondary grain on top of primary mechanical grain. The electrochemical graining was performed using nitric acid and aluminum nitrate under the following conditions:
- Nitric acid concentration:: 15.5 g/l
- Aluminum nitrate concentration:: 60.0 g/l
- A.C. graining current:: 30 Amperes/dm²
(hereafter A/dm²)
The web having combo grain (mechanical grain + electrochemical grain) was anodized to an oxide weight of 1.4 g/m² and the surface was then sealed with polyvinylphosphonic acid as in Example 1. The sealed substrate was coated with a light sensitive coating as described in Example 1. The coated plate was tested for a toning test as described in Example 1. This test plate took 40 sheets to provide acceptable print impressions.

**Example 3:** A 1050 aluminum alloy web was degreased, mechanically grained and etched. The mechanically grained and etched substrate web was then grained with alternating current in nitric acid to form a secondary grain on top of primary mechanical grain. The secondary grain structure was obtained under the following conditions:
- Nitric acid concentration:: 14.5 g/l
- Aluminum nitrate concentration:: 50.0 g/l
- A.C. graining current:: 75 A/dm²
The web having combo grain (mechanical grain + electrochemical grain) was anodized to an oxide weight of 1.4 g/m² and the surface was then sealed with polyvinylphosphonic acid. The sealed substrate was coated with a light sensitive coating as described in Example 1. The coated plate was tested for a toning test as described in Example 1. This test plate took 40 sheets to provide acceptable print impressions.

**Example 4:** A 3103 aluminum alloy web was degreased, mechanically grained and etched. The mechanically grained and etched substrate web was then grained with alternating current in nitric acid to form a secondary grain on top of primary mechanical grain. The secondary grain structure was obtained under the following conditions:
- Nitric acid concentration:: 16.5 g/l
- Aluminum nitrate concentration:: 70.0 g/l
- A.C. graining current:: 150 A/dm²
The web having combo grain (mechanical grain + electrochemical grain) was anodized to an oxide weight of 1.4 g/m² and the surface was then sealed with polyvinylphosphonic acid. The sealed substrate was coated with a light sensitive coating as described in Example 1. The coated plate was tested for a toning test as described in Example 1. This test plate took 40 sheets to provide acceptable print impressions.

**Example 5:** A 3103 aluminum alloy web was degreased, mechanically grained and etched. The mechanically grained and etched substrate web was then grained with alternating current in nitric acid to form a secondary grain on top of primary mechanical grain. The secondary grain structure was obtained under the following conditions:
- Nitric acid concentration:: 14.5 g/l
- Aluminum nitrate concentration:: 50.0 g/l
- A.C. graining current:: 255 A/dm²
The web having combo grain (mechanical grain + electrochemical grain) was anodized to an oxide weight of 1.4 g/m² and the surface was then sealed with polyvinylphosphonic acid. The sealed substrate was coated with a light sensitive coating as described in Example 1. The coated plate was tested for a toning test as described in Example 1. This test plate took 40 sheets to provide acceptable print impressions.

**Example 6:** A 1050 aluminum alloy web was degreased, mechanically grained and etched. The mechanically grained and etched substrate web was then grained with alternating current in nitric acid to form a secondary grain on top of primary mechanical grain. The secondary grain structure was obtained under the following conditions:
- Nitric acid concentration:: 15.0 g/l
- Aluminum nitrate concentration:: 40.0 g/l
- A.C. graining current:: 375 A/dm²
The web having combo grain (mechanical grain + electrochemical grain) was anodized to an oxide weight of 1.4 g/m² and the surface was then sealed with polyvinylphosphonic acid. The sealed substrate was coated with a light sensitive coating as described in Example 1. The coated plate was tested for a toning test as described in Example 1. This test plate took 40 sheets to provide acceptable print impressions.

**Example 7:** A 1050 aluminum alloy web was degreased, mechanically grained and etched. The mechanically grained and etched substrate web was then grained with alternating current in nitric acid to form a secondary grain on top of primary mechanical grain. The secondary grain structure was obtained under the following conditions:
- Nitric acid concentration:: 15.0 g/l
- Aluminum nitrate concentration:: 80.0 g/l
- A.C. graining current:: 500 A/dm²
The web having combo grain (mechanical grain + electrochemical grain) was anodized to an oxide weight of 1.4 g/m² and the surface was then sealed with polyvinylphosphonic acid. The sealed substrate was coated with a light sensitive coating as described in Example 1. The coated plate was tested for a toning test as described in Example 1. This test plate took 40 sheets to provide acceptable print impressions.

**Example 8:** A 1050 aluminum alloy web is degreased, mechanically grained and etched. The mechanically grained and etched substrate web is then grained with alternating current in nitric acid to form a secondary grain on top of primary mechanical grain. The secondary grain structure is obtained under the following conditions:
- Nitric acid concentration:: 15.5 g/l
- Aluminum nitrate concentration:: 60.0 g/l
- A.C. graining current:: 30 A/dm²
The web having combo grain (mechanical grain + electrochemical grain) is anodized to an oxide weight of 1.4 g/m² and the surface is then sealed with partially neutralized polyvinylphosphonic acid (PVPA neutralized with sodium hydroxide to a pH of 4.5). The sealed substrate is then coated with a light sensitive coating as described in Example 1. The coated plate is tested for a toning test as described in Example 1. This test plate takes about 20 sheets to provide acceptable print impressions.

## Claims

1. A process to prepare a lithographic printing plate, sequentially comprising the steps of:
(a) providing a substrate made of a suitable metal;
(b) graining said substrate mechanically;
(c) graining said substrate electrochemically in an acid medium with symmetrical alternating current in the range of about 10-500 Amperes/dm², said acid medium being selected from the group consisting of nitric acid, hydrochloric acid and mixtures thereof;
(d) etching said grained substrate in an acid or base bath;
(e) conditioning said etched substrate with partially neutralized polyvinylphosphonic acid, wherein said partially neutralized polyvinylphosphonic acid is maintained at a pH in the range of about 2.5 to 6;
(f) applying a photosensitive layer to said conditioned substrate;
(g) imagewise exposing said photosensitive layer to actinic radiation in the wavelength range 300-400 nm; and
(h) developing said exposed photosensitive layer in an aqueous developer optionally containing an organic solvent.

2. The process as described in claim 1, wherein said substrate is made of aluminum or steel.

3. The process as described in claim 1, wherein said substrate is made of aluminum.

4. The process as described in claim 1, wherein said mechanical graining in step (b) comprises brush graining in an aqueous slurry comprising a mixture of alumina particulates.

5. The process as described in claim 1, wherein said mechanical graining step comprises brush graining in an aqueous slurry comprising a mixture of quartz particulates.

6. The process as described in claim 1, wherein said mechanical graining step comprises brush graining in an aqueous slurry comprising a mixture of particulates, wherein said mixture comprises alumina and quartz in a weight ratio in the range 95:5 to 5:95 and wherein said particulates have particle size in the range 1-20 microns.

7. The process as described in claim 6, wherein said aqueous slurry has a solids concentration of about 5-50 weight percent.

8. The process as described in claim 1, wherein said acid medium in step (d) comprises nitric acid.

9. The process as described in claim 1, wherein said acid medium in step (d) comprises hydrochloric acid.

10. The process as described in claim 1, wherein said symmetrical alternating current in step (c) is in the range of about 10-300 A/dm².

11. The process as described in claim 1, wherein said symmetrical alternating current in step (c) is in the range of about 20-200 A/dm².

12. The process as described in claim 1, wherein said photosensitive layer in step (f) comprises a photosensitive compound of positive type.

13. The process as described in claim 1, wherein said photosensitive layer in step (f) comprises a photosensitive compound of negative type.

14. The process as described in claim 12, wherein said positive photosensitive compound is a sulfonic acid ester of an ortho-quinone diazide.

15. The process as described in claim 13, wherein said negative photosensitive compound is a diazonium compound.

16. The process as described in claim 15, wherein said diazonium compound is a polycondensation product of 3-methoxy-4-diazo diphenyl amine sulfate and 4,4'-bismethoxy methyl-diphenyl ether, precipitated in the form of mesitylene sulfonate.

17. The process as described in claim 1, wherein said aqueous developer in step (h) is selected from the group consisting of sodium octyl monosulfate, potassium decyl monosulfate, lithium dodecyl monosulfate and combinations thereof.

18. A process to prepare a lithographic printing plate as claimed in claim 1, comprising a reversal in the sequence of the steps (c) and (d) to the steps (d) and (c), while the steps (a), (b) and (e) to (h) remain unchanged in the sequence.

19. The process as described in claim 18, wherein said acid medium in the etching step of said mechanically grained substrate is nitric acid.

20. The process as described in claim 18, wherein said alternating current in the electrochemically graining step is in the range of 10-300 A/dm².

21. A process to prepare a lithographic printing plate, comprising the steps of:
(a) providing an aluminum substrate;
(b) graining said substrate mechanically in an aqueous slurry comprising a mixture of particulates, wherein said mixture comprises alumina and quartz in a weight ratio in the range 95:5 to 5:95 and wherein said particulates have particle sizes in the range 1-20 microns;
(c) graining said substrate electrochemically in a suitable acid medium with symmetrical alternating current in the range of about 10-500 A/dm²;
(d) conditioning said surface with partially neutralized polyvinylphosphonic acid as the conditioning agent wherein said partially neutralized polyvinylphosphonic acid has a pH in the range of about 2.5 to 6;
(e) applying a photosensitive layer to said conditioned substrate;
(f) imagewise exposing said photosensitive layer to actinic radiation in the wavelength range 300-400 nm; and
(g) developing said exposed layer in an aqueous developer optionally containing an organic solvent.

22. The process as described in claim 21, wherein said acid medium in step (c) is nitric acid.

23. The process as described in claim 21, wherein said alternating current in step (c) is in the range of 10-300 A/dm².

24. The process as defined in claim 1 or claim 18, which further comprising anodizing the substrate in an aqueous electrolyte bath, between steps (d) and (e).

25. A lithographic printing plate comprising:
(a) a substrate made of a suitable metal;
(b) said substrate being mechanically grained;
(c) said substrate being electrochemically grained in an acid medium with symmetrical alternating current in the range of about 10-500 A/dm², said acid medium being selected from the group consisting of nitric acid, hydrochloric acid and mixtures thereof;
(d) said grained substrate being etched in an acid or base bath;
(e) said etched substrate being anodized in an aqueous electrolyte bath;
(f) a surface of said anodized substrate being conditioned with partially neutralized polyvinylphosphonic acid having a pH-range of about 2.5 to 6.0;
(g) a photosensitive layer being applied to said conditioned substrate and imagewise exposed to actinic radiation in the wavelength range 300-400 nm; and
(h) said exposed photosensitive layer being developed in an aqueous developer optionally containing an organic solvent.

26. A lithographic printing plate comprising:
(a) an aluminum substrate;
(b) said substrate being mechanically grained in an aqueous slurry comprising a mixture of particulates, wherein said mixture comprises alumina and quartz in a weight ratio in the raqnge 95:5 to 5:95 and wherein said particulates have particle sizes in the range 1-20 microns;
(c) said mechanically grained substrate being electrochemically grained in a suitable acid medium with symmetrical alternating current in the range of about 10-500 A/dm²;
(d) a surface of said electrochemically grained substrate being conditioned with partially neutralized polyvinylphosphonic acid having a pH range of about 2.5 to 6.0;
(e) a photosensitive layer being applied to the conditioned surface and being imagewise exposed to actinic radiation in the wavelength range 300-400 nm; and
(f) said exposed photosensitive layer being developed in an aqueous developer optionally containing an organic solvent.

## Patentansprüche

1. Verfahren zum Herstellen einer lithografischen Druckplatte gemäß den aufeinanderfolgenden Schritten:
a) Bereitstellen eines Trägers aus einem geeigneten Metall;
b) mechanisches Aufrauhen des Trägers;
c) elektrochemisches Aufrauhen des Trägers in einem Säuremedium mittels symmetrischen Wechselstrom im Bereich von 10 - 500 A/dm², wobei das Säuremedium aus der Gruppe bestehend aus Salpetersäure Salzsäure und Mischungen hiervon, ausgewählt wird;
d) Ätzen des aufgerauhten Trägers in einem Säure- oder Basebad;
e) konditionieren des geätzten Trägers mit teilweise neutralisierter Polyvinylphosphonsäure, wobei die Polyvinylphosphonsäure auf einen pH-Wert im Bereich von 2,5 bis 6 gehalten wird;
(f) Aufbringen einer fotoempfindlichen Schicht auf dem konditionierten Träger;
(g) bildweises Belichten der fotoempfindlichen Schicht mit aktinischer Strahlung im Wellenlängenbereich 300 - 400 nm; und
(h) Entwickeln der belichteten fotoempfindlichen Schicht in einem wäßrigen Entwickler, der wahlweise ein organisches Lösungsmittel enthält.

2. Verfahren nach Anspruch 1, dadurch gekennzeichnet, daß der Träger aus Aluminium oder Stahl besteht.

3. Verfahren nach Anspruch 1, dadurch gekennzeichnet, daß der Träger aus Aluminium besteht.

4. Verfahren nach Anspruch 1, dadurch gekennzeichnet, daß das mechanische Aufrauhen im Schritt (b) ein Walzenbürsten in einer wäßrigen Aufschlämmung umfaßt, die eine Mischung aus Aluminiumoxidpartikeln enthält.

5. Verfahren nach Anspruch 1, dadurch gekennzeichnet, daß der mechanische Aufrauhschritt ein Walzenbürsten in einer wäßrigen Aufschlämmung umfaßt, die eine Mischung aus Quarzpartikeln enthält.

6. Verfahren nach Anspruch 1, dadurch gekennzeichnet, daß der mechanische Aufrauhschritt Walzenbürsten in einer wäßrigen Aufschlämmung umfaßt, bestehend aus einer Mischung von Partikeln, wobei diese Mischung Aluminiumoxid und Quarz in einem Gewichtsverhältnis im Bereich von 95:5 bis 5:95 enthält und wobei diese Partikel eine Partikelgröße im Bereich von 1 - 20 Mikron aufweisen.

7. Verfahren nach Anspruch 6, dadurch gekennzeichnet, daß die wäßrige Aufschlämmung eine Feststoffkonzentration von 5 - 50 Gew.-% besitzt.

8. Verfahren nach Anspruch 1, dadurch gekennzeichnet, daß das Säuremedium im Schritt (d) Salpetersäure enthält.

9. Verfahren nach Anspruch 1, dadurch gekennzeichnet, daß das Säuremedium im Schritt (d) Salzsäure enthält.

10. Verfahren nach Anspruch 1, dadurch gekennzeichnet, daß der symmetrische Wechselstrom im Schritt (c) im Bereich von 10 - 300 A/dm² liegt.

11. Verfahren nach Anspruch 1, dadurch gekennzeichnet, daß der symmetrische Wechselstrom im Schritt (c) im Bereich von 20 - 200 A/dm² liegt.

12. Verfahren nach Anspruch 1, dadurch gekennzeichnet, daß die fotoempfindliche Schicht im Schritt (f) eine fotoempfindliche Verbindung des positiven Typs enthält.

13. Verfahren nach Anspruch 1, dadurch gekennzeichnet, daß die fotoempfindliche Schicht im Schritt (f) eine fotoempfindliche Verbindung des negativen Typs enthält.

14. Verfahren nach Anspruch 12, dadurch gekennzeichnet, daß die positiv arbeitende fotoempfindliche Verbindung ein Sulfonsäureester eines ortho-Chinondiazids enthält.

15. Verfahren nach Anspruch 13, dadurch gekennzeichnet, daß die negativ arbeitende fotoempfindliche Verbindung eine Diazoniumverbindung ist.

16. Verfahren nach Anspruch 15, dadurch gekennzeichnet, daß die Diazoniumverbindung ein Polykondensationsprodukt von 3-Methoxy-4-diazo-diphenylaminsulfat und 4,4'-Bis-meth-oxy-methyl-diphenylether ist, ausgefällt in Gestalt von Mesitylensulfonat.

17. Verfahren nach Anspruch 1, dadurch gekennzeichnet, daß der wäßrige Entwickler im Schritt (h) aus der Gruppe ausgewählt ist, die Natriumoctylmonosulfat, Kaliumdecylmonosulfat, Lithiumdodecylmonosulfat und Kombinationen hiervor umfaßt.

18. Verfahren zum Herstellen einer lithografischen Druckplatte nach Anspruch 1, gekennzeichnet durch eine Umkehr in der Reihenfolge der Schritte (c) und (d) zu den Schritten (d) und (c), während die Schritte (a), (b) und (e) bis (h) in ihrer Reihenfolge unverändert bleiben.

19. Verfahren nach Anspruch 18, dadurch gekennzeichnet, daß das Säuremedium im Ätzschritt des mechanisch aufgerauhten Trägers Salpetersäure ist.

20. Verfahren nach Anspruch 18, dadurch gekennzeichnet, daß der Wechselstrom im elektrochemischen Aufrauhschritt im Bereich von 10 - 300 A/dm² liegt.

21. Verfahren zum Herstellen einer lithografischen Druckplatte, umfassend die Schritte,
(a) Bereitstellen eines Aluminiumträgers;
(b) Aufrauhen dieses Trägers mechanisch in einer wäßrigen Aufschlämmung bestehend aus einer Mischung von Partikeln, wobei diese Mischung Aluminiumoxid und Quarz in einem Gewichtsverhältnis im Bereich 95:5 bis 5:95 umfaßt und diese Partikel eine Partikelgröße im Bereich von 1 - 20 Mikron besitzen;
(c) elektrochemisches Aufrauhen des Trägers in einem geeigneten Säuremedium mittels symmetrischen Wechselstroms in dem Bereich von 10 -500 A/dm²;
(d) Konditionieren der Oberfläche mit teilweise neutralisierter Polyvinylphosphonsäure als Konditionierungsmittel, wobei die teilweise neutralisierte Polyvinylphosphonsäure einen pH-Wert von 2,5 bis 6 aufweist;
(e) Aufbringen einer fotoempfindlichen Schicht auf dem konditionierten Träger;
(f) bildweises Belichten der fotoempfindlichen Schicht mit aktinischer Strahlung im Wellenlängen 300 - 400 nm; und
(g) Entwickeln der belichteten Schicht in einem wäßrigen Entwickler, der wahlweise ein organisches Lösungsmittel enthält.

22. Verfahren nach Anspruch 21, dadurch gekennzeichnet, daß das Säuremedium im Schritt (c) Salpetersäure ist.

23. Verfahren nach Anspruch 21, dadurch gekennzeichnet, daß der Wechselstrom im Schritt (c) im Bereich von 10 - 300 A/dm² liegt.

24. Verfahren nach Anspruch 1 oder Anspruch 18, dadurch gekennzeichnet, daß der Träger in einem wäßrigen Elektrolytbad zwischen den Schritten (d) und (e) anodisiert wird.

25. Lithografische Druckplatte bestehend aus:
(a) einem Träger aus einem geeigneten Metall;
(b) dieser Träger ist mechanisch aufgerauht;
(c) der Träger ist des weiteren elektrochemisch aufgerauht in einem Säuremedium mit symmetrischem Wechselstrom im Bereich von 10 - 500 A/dm², wobei das Säuremedium aus einer Gruppe ausgewählt ist, die Salpetersäure, Salzsäure und Mischungen hiervon enthält;
(d) der aufgerauhte Träger ist in einem Säure- oder Basebad geätzt;
(e) der geätzte Träger ist in einem wäßrigen Elektrolytbad anodisiert;
(f) eine Oberfläche des anodisierten Trägers ist mit teilweise neutralisierter Polyvinyl-phosphonsäure, die einen pH-Bereich von 2,5 bis 6,0 besitzt, konditioniert;
(g) eine fotoempfindliche Schicht ist auf dem konditionierten Träger aufgebracht und bildweise mit einer aktinischen Strahlung im Wellenlängenbereich 300 - 400 nm belichtet; und
(h) die belichtete fotoempfindliche Schicht ist in einem wäßrigen Entwickler entwickelt, der wahlweise ein organisches Lösungsmittel enthält.

26. Lithografische Druckplatte bestehend aus:
(a) einem Aluminiumträger;
(b) dieser Träger ist mechanisch in einer wäßrigen Aufschlämmung aufgerauht, die eine Mischung aus Partikeln enthält, wobei diese Mischung Aluminiumoxid und Quarz in einem Mischverhältnis im Bereich 95:5 bis 5:95 aufweist und diese Partikel eine Partikelgröße im Bereich von 1 - 20 Mikron besitzen;
(c) dieser mechanisch aufgerauhte Träger ist elektrochemisch in einem geeigneten Säuremedium mit symmetrischem Wechselstrom im Bereich von 10 - 500 A/dm² aufgerauht;
(d) eine Oberfläche des elektrochemisch aufgerauhten Trägers ist mit teilweise neutralisierter Polyvinylphosphonsäure mit einem pH-Bereich von 2,5 bis 6,0 konditioniert;
(e) eine fotoempfindliche Schicht ist auf der konditionierten Oberfläche aufgebracht und ist bildweise mit aktinischer Strahlung im Wellenlängenbereich 300 - 400 nm belichtet; und
(f) die belichtete fotoempfindliche Schicht ist in einem wäßrigen Entwickler entwickelt, der wahlweise ein organisches Lösungsmittel enthält.

## Revendications

1. Procédé pour préparer une plaque d'impression lithographique comprenant successivement les étapes suivantes :
(a) fournir un substrat constitué d'un métal approprié ;
(b) grainer ledit substrat mécaniquement ;
(c) grainer ledit substrat électrochimiquement dans un milieu acide avec un courant alternatif symétrique compris dans l' intervalle d'environ 10 à 500 ampères/dm², ledit milieu acide étant choisi dans le groupe formé par l'acide nitrique, l'acide chlorhydrique et leurs mélanges ;
(d) décaper ledit substrat grainé dans un bain acide ou basique ;
(e) conditionner ledit substrat décapé avec de l'acide polyvinylphosphonique partiellement neutralisé, ledit acide polyvinylphosphonique partiellement neutralisé étant maintenu à un pH compris dans l'intervalle d'environ 2,5 à 6 ;
(f) appliquer une couche photosensible audit substrat conditionné ;
(g) exposer selon une image ladite couche photosensible à un rayonnement actinique dans l'intervalle de longueur d'onde de 300 à 400 nm ; et
(h) développer ladite couche photosensible exposée dans un révélateur aqueux contenant facultativement un solvant organique.

2. Procédé tel que décrit dans la revendication 1, dans lequel ledit substrat est constitué d'aluminium ou d'acier.

3. Procédé tel que décrit dans la revendication 1, dans lequel ledit substrat est constitué d'aluminium.

4. Procédé tel que décrit dans la revendication 1, dans lequel ledit grainage mécanique de l'étape (b) comprend un grainage à la brosse dans une suspension aqueuse comprenant un mélange de particules d'alumine.

5. Procédé tel que décrit dans la revendication 1, dans lequel ladite étape de grainage mécanique comprend un grainage à la brosse dans une suspension aqueuse comprenant un mélange de particules de quartz.

6. Procédé tel que décrit dans la revendication 1, dans lequel ladite étape de grainage mécanique comprend un grainage à la brosse dans une suspension aqueuse comprenant un mélange de particules, ledit mélange comprenant de l'alumine et du quartz en un rapport en poids situé dans l'intervalle de 95:5 à 5:95 et lesdites particules ayant une taille comprise dans l'intervalle de 1 à 20 micromètres.

7. Procédé tel que décrit dans la revendication 6, dans lequel ladite suspension aqueuse a une concentration en matières solides d'environ 5 à 50 pour cent en poids.

8. Procédé tel que décrit dans la revendication 1, dans lequel ledit milieu acide de l'étape (d) comprend l'acide nitrique.

9. Procédé tel que décrit dans la revendication 1, dans lequel ledit milieu acide de l'étape (d) comprend l'acide chlorhydrique.

10. Procédé tel que décrit dans la revendication 1, dans lequel ledit courant alternatif symétrique de l'étape (c) est compris dans l'intervalle d'environ 10 à 300 A/dm².

11. Procédé tel que décrit dans la revendication 1, dans lequel ledit courant alternatif symétrique de l'étape (c) est compris dans l'intervalle d'environ 20 à 200 A/dm².

12. Procédé tel que décrit dans la revendication 1, dans lequel ladite couche photosensible de l'étape (f) comprend un composé photosensible de type positif.

13. Procédé tel que décrit dans la revendication 1, dans lequel ladite couche photosensible de l'étape (f) comprend un composé photosensible de type négatif.

14. Procédé tel que décrit dans la revendication 12, dans lequel ledit composé photosensible positif est un ester d'acide sulfonique d'un *ortho*-quinone-diazide.

15. Procédé tel que décrit dans la revendication 13, dans lequel ledit composé photosensible négatif est un composé de diazonium.

16. Procédé tel que décrit dans la revendication 15, dans lequel ledit composé de diazonium est un produit de polycondensation du sulfate de 3-méthoxy-4-diazo-diphénylamine et de 4,4'-bisméthoxyméthyl(oxyde de diphényle), précipité sous la forme de mésitylène-sulfonate.

17. Procédé tel que décrit dans la revendication 1, dans lequel ledit révélateur aqueux de l'étape (h) est choisi dans le groupe formé par le monosulfate d'octyle et de sodium, le monosulfate de décyle et de potassium, le monosulfate de dodécyle et de lithium, et leurs mélanges.

18. Procédé pour préparer une plaque d'impression lithographique tel que revendiqué dans la revendication 1, comprenant une inversion de l'ordre de succession des étapes (c) et (d) en les étapes (d) et (c), tandis que l'ordre de succession des étapes (a), (b) et (e) à (h) reste inchangé.

19. Procédé tel que décrit dans la revendication 18, dans lequel ledit milieu acide de l'étape de décapage dudit substrat grainé mécaniquement est de l'acide nitrique.

20. Procédé tel que décrit dans la revendication 18, dans lequel ledit courant alternatif de l'étape de grainage électrochimique est compris dans l'intervalle de 10 à 300 A/dm².

21. Procédé pour préparer une plaque d'impression lithographique, comprenant les étapes suivantes :
(a) fournir un substrat en aluminium ;
(b) grainer ledit substrat mécaniquement dans une suspension aqueuse comprenant un mélange de particules, ledit mélange comprenant de l'alumine et du quartz en un rapport en poids situé dans l'intervalle de 95:5 à 5:95 et lesdites particules ayant des tailles comprises dans l'intervalle de 1 à 20 micromètres ;
(c) grainer ledit substrat électrochimiquement dans un milieu acide approprié avec un courant alternatif symétrique compris dans l'intervalle d'environ 10 à 500 A/dm² ;
(d) conditionner ladite surface avec de l'acide polyvinylphosphonique partiellement neutralisé comme agent de conditionnement, ledit acide polyvinylphosphonique partiellement neutralisé ayant un pH situé dans l'intervalle d'environ 2,5 à 6 ;
(e) appliquer une couche photosensible audit substrat conditionné ;
(f) exposer selon une image ladite couche photosensible à un rayonnement actinique dans l'intervalle de longueur d'onde de 300 à 400 nm ; et
(g) développer ladite couche exposée dans un révélateur aqueux contenant facultativement un solvant organique.

22. Procédé tel que décrit dans la revendication 21, dans lequel ledit milieu acide de l'étape (c) est de l'acide nitrique.

23. Procédé tel que décrit dans la revendication 21, dans lequel ledit courant alternatif de l'étape (c) est compris dans l'intervalle de 10 à 300 A/dm².

24. Procédé tel que défini dans la revendication 1 ou la revendication 18, qui consiste de plus à anodiser le substrat dans un bain d'électrolyte aqueux entre les étapes (d) et (e).

25. Plaque d'impression lithographique comprenant :
(a) un substrat constitué d'un métal approprié ;
(b) ledit substrat étant grainé mécaniquement ;
(c) ledit substrat étant grainé électrochimiquement dans un milieu acide avec un courant alternatif symétrique compris dans l'intervalle d'environ 10 à 500 A/dm², ledit milieu acide étant choisi dans le groupe formé par l'acide nitrique, l'acide chlorhydrique et leurs mélanges ;
(d) ledit substrat grainé étant décapé dans un bain acide ou basique ;
(e) ledit substrat décapé étant anodisé dans un bain d'électrolyte aqueux ;
(f) une surface dudit substrat anodisé étant conditionnée avec de l'acide polyvinylphosphonique partiellement neutralisé ayant un intervalle de pH d'environ 2,5 à 6,0 ;
(g) une couche photosensible étant appliquée audit substrat conditionné et exposée selon une image à un rayonnement actinique dans l'intervalle de longueur d'onde de 300 à 400 nm ; et
(h) ladite couche photosensible exposée étant développée dans un révélateur aqueux contenant facultativement un solvant organique.

26. Plaque d'impression lithographique comprenant :
(a) un substrat en aluminium ;
(b) ledit substrat étant grainé mécaniquement dans une suspension aqueuse comprenant un mélange de particules, ledit mélange comprenant de l'alumine et du quartz en un rapport en poids situé dans l'intervalle de 95:5 à 5:95 et lesdites particules ayant des tailles comprises dans l'intervalle de 1 à 20 micromètres ;
(c) ledit substrat grainé mécaniquement étant grainé électrochimiquement dans un milieu acide approprié avec un courant alternatif symétrique compris dans l'intervalle d'environ 10 à 500 A/dm² ;
(d) une surface dudit substrat grainé électrochimiquement étant conditionnée avec de l'acide polyvinylphosphonique partiellement neutralisé ayant un intervalle de pH d'environ 2,5 à 6,0 ;
(e) une couche photosensible étant appliquée à la surface conditionnée et étant exposée selon une image à un rayonnement actinique dans l'intervalle de longueur d'onde de 300 à 400 nm ; et
(f) ladite couche photosensible exposée étant développée dans un révélateur aqueux contenant facultativement un solvant organique.
